# EUROPÄISCHE PATENTSCHRIFT

(11) **EP 1 938 340 B1**
(45) Veröffentlichungstag und Bekanntmachung des Hinweises auf die Patenterteilung: **15.07.2015**
(21) Anmeldenummer: 06793250.9
(22) Anmeldetag: 05.09.2006
(51) Int. Cl.: H01B 3/00, B22F 1/02, C23C 16/44

(54) **VERFAHREN ZUM HERSTELLEN EINES METALLPULVERS UND EINES ELEKTRISCH ISOLIERENDEN KUNSTSTOFFVERBUNDWERKSTOFFES, KUNSTSTOFFVERBUNDWERKSTOFF UND ELEKTRONISCHES BAUTEIL**
METHOD FOR PRODUCING A METAL POWDER AND AN ELECTRICALLY INSULATING POLYMER COMPOSITE MATERIAL, POLYMER COMPOSITE MATERIAL AND ELECTRONIC DEVICE
PROCEDE POUR PRODUIRE UNE POUDRE METALLIQUE ET UN COMPOSITE PLASTIQUE ISOLANT ELECTRIQUE, COMPOSITE PLASTIQUE ET COMPOSANT ELECTRONIQUE

(30) Priorität: 05.09.2005 DE 102005042109
(43) Veröffentlichungstag der Anmeldung: 02.07.2008
(73) Patentinhaber: Fraunhofer-Gesellschaft zur Förderung der angewandten Forschung e.V., 80686 München (DE)
(72) Erfinder: GRÖPPEL, Peter, 91052 Erlangen (DE); IHDE, Jörg, 28865 Lilienthal (DE); BAALMANN, Alfred, 27711 Osterholz-Scharmbeck (DE); SALZ, Dirk, 28777 Bremen (DE); SCHREYER, Michael, 91085 Weisendorf (DE); DONNER, Peter, 91334 Hemhofen (DE); PIECHA, Gerhard, 90439 Nürnberg (DE)
(74) Vertreter: Eisenführ Speiser
(86) Internationale Anmeldenummer: PCT/EP2006/066041
(87) Internationale Veröffentlichungsnummer: WO 2007/028798

(56) Entgegenhaltungen:
- WO-A2-2004/052547
- GB-A- 817 074
- JP-A- 60 047 004
- JP-A- 60 121 201
- JP-A- S58 100 601
- JP-A- S61 073 802
- JP-A- 2001 313 208
- JP-A- 2004 281 169
- US-A- 5 176 938
- US-A- 5 718 753
- US-A- 6 024 915
- US-A1- 2004 265 615
- PICKARD W F: "Base to apex thermal conductance of a cone embedded in a non-ideal insulator" INTERNATIONAL JOURNAL OF HEAT AND MASS TRANSFER, PERGAMON PRESS, GB, Bd. 47, Nr. 24, November 2004 (2004-11), Seiten 5271-5283, XP004568981 ISSN: 0017-9310

## Beschreibung

Die Erfindung betrifft ein Verfahren zum Beschichten eines Metallpulvers, ein Verfahren zum Herstellen eines Kunststoffverbundwerkstoffes, beschichtete Partikel, einen Kunststoffverbundwerkstoff, ein elektronisches Bauteil sowie unterschiedliche Verwendungen der beschichteten Partikel bzw. des Kunststoffverbundwerkstoffes.

Um elektrotechnische oder elektronische Bauteile vor Umwelteinflüssen, wie beispielsweise Feuchtigkeit, Luftsauerstoff, mechanische Belastungen oder Staub zu schützen, sind diese in der Regel mit einer Schutzschicht aus Kunststoff versehen. Die zunehmende Miniaturisierung und Leistungssteigerung elektronischer Bauteile führt jedoch zu einem Anstieg der volumenbezogenen Verlustleistung. Die damit verbundene thermische Belastung der Bauteile und deren Kunststoffschutzschichten kann die Lebensdauer des Bauteils verkürzen oder dessen Zuverlässigkeit verringern.

Um die thermische Leitfähigkeit der Kunststoffhülle zu verbessern, werden deshalb dem Kunststoff Füllstoffe beigemischt. Der daraus entstehende Kunststoff-Verbundwerkstoff (Kunststoff Composite) muss jedoch elektrisch isolierend sein. Deshalb sind nur relativ wenige Materialien als Füllstoff geeignet. Beispiele solcher Materialien sind u.a. Karbonate, Karbide, Nitride, Tone, Silikate, Oxide, Ferrite, Sulfate und Titanate (vgl. W.C. "Fillers for Plastics", Light Books London, 1971, Seite 13). In der Praxis werden aufgrund der relativ guten thermischen Eigenschaften insbesondere Glas, Quarzmehl, Quarzgut, Aluminiumoxid, Bornitrid, Aluminiumnitrid, Titandioxid, Zinkoxid und Siliziumkarbid verwendet.

Der Einsatz von Glas oder Quarzmehl oder Quarzgut als Füllstoff in den Kunststoffen erfolgt zumeist nicht mit der Zielsetzung der Erhöhung der Wärmeleitfähigkeit des daraus resultierenden Kunststoff-Verbundwerkstoffes, sondern um eine Erhöhung des E-Moduls, eine Verringerung des thermischen Ausdehnungskoeffizienten, Verringerung der Feuchtigkeitsaufnahme und - Permeation oder eine Verringerung des Materialpreises zu erreichen.

Siliziumkarbid weist in Abhängigkeit seiner Reinheit eine thermische Leitfähigkeit von 60 W/mK bis 160 W/mK auf. Trotz dieser relativ hohen thermischen Leitfähigkeit kann Siliziumkarbid aufgrund seiner elektrischen Teilleitfähigkeit nur bedingt eingesetzt werden.

Auch Aluminiumnitrid weist eine sehr hohe thermische Leitfähigkeit von bis zu 200 W/mK auf. In Gegenwart von Wasser oder Luftfeuchtigkeit kann es sich jedoch in Aluminiumoxid und Ammoniak zersetzen. Letzteres ist aber aufgrund seiner korrosiven Eigenschaften auf metallischen Oberflächen in der Elektronikindustrie sehr ungern gesehen, wodurch der Einsatz von Aluminiumnitrid stark limitiert ist.

Bornitrid dagegen hydrolysiert erst bei sehr hohen Temperaturen. Es ist aus hexagonalen Strukturen aufgebaut, wodurch sich sein makroskopisches Auftreten in Form von hexagonalen Plättchen ergibt. Entlang der Plättchenebene weist es zwar eine thermische Leitfähigkeit von etwa 400 W/mK auf, senkrecht dazu jedoch lediglich 2 W/mK. Diese Anisotropie der Wärmeleitfähigkeit ist in der praktischen Anwendung problematisch. Die Plättchenform limitiert dabei zusätzlich die Menge des in einem Kunststoff einzubringenden Füllstoffanteiles, da die Plättchenform zu einer Erhöhung der Viskosität führt.

Zur Erhöhung der Wärmeleitfähigkeit des Kunststoffes für die Schutzummantelung wird Aluminiumoxid überwiegend in der Form von α-Al₂O₃ eingesetzt. Die thermische Wärmeleitfähigkeit liegt lediglich bei 25-40 W/mK.

Mit Ausnahme von Glas und Quarzgut werden die anderen Füllstoffe in nicht sphärischer Form vertrieben. Die erreichbare Packungsdichte ist bei sphärischen Partikeln hoch, während die Packungsdichte und die Verarbeitungsmöglichkeiten mit steigendem Aspektverhältnis überproportional absinken.

Die Herstellung von metallischen Partikeln mit einer plasmapolymeren Beschichtung ist z.B. aus JP 60047004 oder JP 61073802 bekannt.

Es besteht also ein Bedarf an gegenüber einigen oder allen vorgenannten Nachteilen verbesserten Bestandteilen für Kunststoffverbundwerkstoffe. Dementsprechend ist die Aufgabe der vorliegenden Erfindung, ein Verfahren zur Herstellung solcher Bestandteile anzugeben. Eine weitere Aufgabe der vorliegenden Erfindung ist es, die Bestandteile für Kunststoffverbundwerkstoffe mit verbesserten Eigenschaften anzugeben sowie weitere Verwendungen dieser Bestandteile zu offenbaren.

Die erste Aufgabe der Erfindung wird gelöst durch ein Verfahren zum Beschichten eines Metallpulvers, aufweisend folgenden Verfahrensschritt: Beschichten der einzelnen Partikel (P) eines Metallpulvers mit einer Schicht (S), wobei für die Beschichtung der einzelnen Partikel (P) eine Gasphasenabscheidung, insbesondere eine Plasmaquelle verwendet wird.

Unter Gasphasenabscheidung sind in diesem Text nur solche Abscheidungen zu verstehen, bei denen der zur Abscheidung verwendete Precursor in der Gasphase derart fragmentiert wird, dass es aufgrund dieser Fragmentierung zu einer Polymerisation der abzuscheidenden Substanz in der Gasphase oder auf einer Oberfläche kommt.

Durch den Einsatz der Gasphasenabscheidung mittels einer Plasmaquelle, wird in dem erfindungsgemäßen Verfahren eine Plasmapolymerisation durchgeführt. Dabei wird eine gasförmige Substanz, die mindestens Kohlenstoff-, Silicium- und/oder Schwefelatome enthält, in einem Plasma angeregt und fragmentiert. Die Anregung und Fragmentierung der Moleküle dieser Substanz, insbesondere eines plasmapolymersierbaren Precursors (oft auch Monomeres genannt) in gas- oder dampfförmigem Zustand, erfolgt durch den Beschuss mit Elektronen und/oder energiereichen Ionen und/oder energiereichen Photonen. Dabei entstehen geladene oder elektrisch neutrale angeregte Molekülfragmente, die miteinander im Gasraum reagieren können. Weiterhin können sie durch Stoßwechselwirkung mit einer Oberfläche elektrisch neutralisiert, und/oder abgeregt und/oder reflektiert werden. Zudem können die Molekülfragmente oder auch ihre Reaktionsprodukte auf einer Oberfläche abgeschieden werden und dort zu einer Schichtbildung führen, häufig unter Ausbildung chemischer Bindungen.

Auf diese abgeschiedene Schicht wirkt die elektrische Entladung des Plasmas und dessen Ionen- und Elektronen- und Photonenbeschuss fortwährend ein, so dass in der abgeschiedenen Schicht weitere Reaktionen ausgelöst werden, wie zum Beispiel die Bildung von freien Bindungen unter Abspaltung von Atomen oder Molekülfragmenten. Diese freien Bindungen können entweder durch die Anbindung von reaktiven Spezies aus der Gasphase oder durch die schichtinterne Vernetzung mit benachbarten freien Bindungen rekombinieren. Dadurch kann eine hochgradige Vernetzung innerhalb der Beschichtung erzielt werden.

Bei der Plasmapolymerisation bleibt die Höhenstruktur, das Relief und die Topographie der zu beschichtenden Oberfläche weitgehend erhalten. Dies wird oft als Nachbildung der Oberflächenstruktur beschrieben.

Generell hängen die Eigenschaften von plasmapolymeren Schichten von dem eingesetzten Monomer und den Herstellungsbedingungen ab. Plasmapolymere Schichten unterscheiden sich von Polymeren beispielsweise hinsichtlich ihrer Struktur durch die typischen Eigenschaften von Plasmapolymeren deutlich:
- Die Struktur von Plasmapolymeren hat mit der Struktur der eingesetzten Monomere aufgrund der Fragmentierung während der Plasmaanregung kaum noch etwas gemeinsam.
- Durch die Fragmentierung während der Plasmaanregung zeigen die plasmapolymeren Schichten keine regelmäßigen Strukturen.
- Plasmapolymere sind hochvernetzt, können aber trotzdem noch Doppelbindungen aufweisen.
- Plasmapolymere Schichten verfügen im Regelfall nach der Herstellung über langlebige, freie Radikale, die erst im Laufe der Zeit durch Luftsauerstoff und/oder -feuchtigkeit abgesättigt werden.
- Plasmapolymere Schichten weisen keine Taktizität auf (das heißt es gibt keine Regelmäßigkeit, mit der konfigurative Repetiereinheiten aufeinanderfolgen), da sie nicht durch koordinierte Kettenreaktionen entstehen.
- Plasmapolymere Schichten sind amorph.

Bevorzugt bestehen die für die Erfindung zum Einsatz kommenden plasmapolymeren Schichten aus Silizium, Sauerstoff, Kohlenstoff, Wasserstoff und/oder Fluor.

Bevorzugt wird für das bevorzugte erfindungsgemäße Verfahren eine Düse für die Plasmaabscheidung mit folgenden Eigenschaften verwendet:

Die Plasmaquelle liegt außerhalb der Düse. Die Düse ist so aufgebaut, dass das bevorzugt in einer Atmosphärendruck-Plasmaquelle erzeugte Plasma in den Reaktionsraum (die Düse) aufgrund des in der Plasmaquelle eingesetzten Ionisationsgasstromes einströmt. Der Aufbau der Einspeisung des Plasmastrahles aus der Plasmaquelle in die verwendete Düse, die auch als Reaktionsraum bezeichnet wird, ist so gewählt, dass das einströmende Gas aufgrund der geometrischen Auslegung der Einspeisung eine Verwirbelung erfährt. Diese Verwirbelung wird ausgenutzt, um den von der Seite in die Düse eingespeisten Precursor in geeigneter Weise gleichmässig mit dem Plasmastrahl zu durchmischen. Desweiteren wird die Verwirbelung des eintretenden Plasmastrahles genutzt, um das zu beschichtende metallische Pulver in geeigneter Weise gleichmäßig in dem mit dem Precursor vermischten Plasmastrahl einzubringen. Bevorzugt erfolgt die Einspeisung des Plasmastrahles in die Düse derart, dass eine wenigstens unterstützende Strömung und/oder ein unterstützender Sog auf die Einspeisung des Precursors und/oder des metallischen Pulvers entsteht. Metallisches Pulver und/oder der Precursor können per Trägergas in die Düse eingespeist werden. In einer bevorzugten Ausgestaltung der Düse liegen sich die Einspeisungsöffnungen für metallisches Pulver und den Precursor gegenüber.

Die Gasverwirbelung innerhalb der Düse und die Führung der unbeschichteten und (teil-)beschichteten Metallpartikel und des Precursors (beziehungsweise der in dem Plasma gebildeten Reaktionsprodukte des Precursors) innerhalb des strömenden Gases ist aufgrund der geometrischen Auslegung der Düse so gewählt, dass sich eine geeignete Verweildauer der zu beschichtenden metallischen Partikel im den gebildeten reaktiven, schichtabscheidenden Gasvolumen ergibt. Die Verweildauer der Partikel und des Precursors, beziehungsweise der in dem Plasma gebildeten Reaktionsprodukte des Precursors, ist dabei so zu wählen, dass zum einen die Schichtabscheidung auf den zu beschichtenden Partikeln in der angestrebten Schichtdicke erfolgt. Zum anderen ist darauf zu achten, dass die Umsetzung des Precursors, das heißt die im Plasma erfolgende Fragmentierung und die Bildung von Reaktionsprodukten in der Gasphase, derart erfolgen kann, dass die angestrebten Eigenschaften der abzuscheidenden Schichten insbesondere eine möglichst vollständige Umhüllung der einzelnen Metallpartikel erreicht werden. Die dafür nötigen Maßnahmen sind für den Fachmann unschwer zu ermitteln.

Der Vorteil des Einsatzes einer Düse mit den beschriebenen Eigenschaften gegenüber den bereits bekannten und beschriebenen Düsen zur Plasmapolymerisation bei Atmosphärendruck liegt insbesondere darin, dass sich bei ihrer Verwendung die Stoßzahl der beschichteten Partikel untereinander deutlich verringert, so dass sich mechanische Schäden an der plasmapolymeren Beschichtung verringern und die Beschichtung der Partikel des Metallpulvers zu einem höheren Grade vervollständigt ist.

Die erfindungsgemäßen beschichteten Partikel des Metallpulvers werden als ein Aspekt der Erfindung zum Herstellen eines Kunststoffverbundwerkstoffes verwendet, indem die beschichteten Partikel mit einem Kunststoff vermischt werden. Geeignete Kunststoffe sind u.a. Thermoplaste, Duroplaste, Elastomere.

Ein Grundgedanke der vorliegenden Erfindung ist es, als Füllstoff für den Kunststoff-Verbundwerkstoff ein Metallpulver zu verwenden, das an sich elektrisch leitfähig ist. Ein Vorteil eines Metallpulvers ist dessen hohe Wärmeleitfähigkeit von zum Beispiel 400W/mK bei Kupfer, wodurch Vorraussetzungen geschaffen sind, dass der entsprechende Kunststoff-Verbundwerkstoff ebenfalls eine hohe Wärmeleitfähigkeit zwischen 2 und 20W/mK hat. Bevorzugt ist, dass trotz der Verwendung eines Metallpulvers als Füllmischung der entstehende Kunststoff-Verbundwerkstoff elektrisch isolierend ist, um als Schutzhülle z.B. eines elektronischen Bauteils überhaupt verwendet werden zu können. Daher werden erfindungsgemäß die einzelnen Partikel bevorzugt mit der elektrisch isolierenden Schicht versehen.

Der Vorteil von der Verwendung eines Metallpulvers als Füllstoff für den Kunststoff ist die gute thermische Leitfähigkeit von Metallen. So hat beispielsweise Aluminium eine thermische Leitfähigkeit von etwa 260 W/mK, Kupfer eine thermische Leitfähigkeit von etwa 400 W/mK, Silber eine thermische Leitfähigkeit von etwa 430 W/mK und Magnesium eine thermische Leitfähigkeit von etwa 150 W/mK. Insbesondere diese genannten Metalle, aber auch andere Metalle wie Nickel (85 W/mK), Kobalt (100 W/mK), Eisen (80 W/mK), Titan (22 W/mK), Zink (110 W/mK), Gold (310 W/mK), Legierungen der Metalle oder Gemische der Metalle werden daher gemäß einer bevorzugten Ausführungsform verwendet.

Die Verwendung von Eisen ist erfindungsgemäß möglich und in einigen Fällen auch sinnvoll, ist aber weniger bevorzugt als die Verwendung anderer insbesondere anderer genannter Edelmetalle, da Eisen verhältnismäßig korrosionsanfällig ist und schon bei der Herstellung als geeignetes Pulver eine Reihe von Nachteilen besitzt wie z.B. erschwerte Bedingungen, falls sphärische Partikel gewünscht sind, diese in einer akzeptablen Größenverteilung bei geeigneten Prozesskosten zu erhalten. Außerdem kann Eisen Schwierigkeiten beim Recycling von Verbundwerkstoffen bereiten. Aufgrund der erschwerten Herstellungsbedingungen der für bestimmte Anwendungen gewünschten Eisenpulver ist zudem sogar der Einsatz von edleren Metallen wie z.B. Kupfer, Silber oder Gold kostengünstiger.

**Die meisten der oben explizit genannten Metalle besitzen gegenüber Eisen den Vorteil einer höheren thermischen Leitfähigkeit. Titan hat zwar eine geringere Wärmeleitfähigkeit als Eisen, besitzt aber gegenüber Eisen eine geringere Dichte, ist korrosionsstabil nach Oxidbildung und besitzt Vorteile bei der Erzielung von Farbeffekten**.Neben der thermischen Leitfähigkeit weisen Metalle allgemein weitere günstige Eigenschaften auf. So sind Metalle relativ preisgünstig und sind als Partikel in verschiedenen Größen kommerziell verfügbar. Aufgrund der relativ niedrigen Schmelztemperaturen von Metallen können sie durch Gasverdüsung hergestellt werden, so dass sie auch in sphärischer Form vorliegen. Insbesondere Kupfer findet in sphärischer Form als Bestandteil von Lötpasten große Anwendung.

Ein Vorteil von sphärischen Partikeln ist es, dass wenn sie dem Kunststoff beigemischt sind, mit ihnen durch Verwendung multimodaler Gemische eine relativ hohe Packungsdichte erreicht werden kann. So können bei geeigneter Kombination tri- oder multimodale Gemische sphärischer Partikel Volumenfüllgrade von bis 86% oder mehr erreicht werden. Dadurch kann die Wärmeleitfähigkeit des Kunststoffverbundwerkstoffes erhöht werden. Außerdem führt die Verwendung sphärischer Metallpulver dazu, die Viskosität des Kunststoffverbundwerkstoffes im Vergleich zum Ausgangskunststoff nur relativ wenig zu erhöhen, sodass ein durch das erfindungsgemäße Verfahren hergestellter Kunststoffverbundwerkstoff eine geringere Viskosität hat, als ein geläufiger Kunststoffverbundwerkstoff, dessen Füllstoffe ein ausgeprägtes Aspektverhältnis haben, wie zum Beispiel Bornitrid.

Ein weiterer Vorteil bei der Verwendung eines Metallpulvers als Füllstoff in dem Kunststoff ist es, dass ein solcher Kunststoff-Verbundwerkstoff als Schutzhülle eines elektronischen Bauteiles auch eine elektromagnetische Abschirmwirkung aufweist. Dadurch kann die elektromagnetische Verträglichkeit des entsprechenden elektronischen Bauteiles erhöht werden.

Ein elektrisches System ist dann elektromagnetisch verträglich mit seiner Umwelt, wenn bestimmte Grenzwerte von Emission und Immunität eingehalten werden. Die Emission beschreibt dabei die Abstrahlung eines elektrischen Bauteils oder Systems. Da diese Abstrahlung von der unmittelbaren Umgebung als Störung empfunden werden kann, werden Grenzwerte von internationalen Normen definiert und entsprechend begrenzt. In Europa wird dieser Teilaspekt in der CISPR 22/ EN 55022 spezifiziert. Bei der Immunität handelt es sich um die Störfestigkeit eines elektrischen Bauteils oder Systems.

Elektromagnetische Unverträglichkeit führt zur gegenseitigen Beeinflussung von elektronischen Geräten durch elektromagnetische Wellen, die eine Fehlfunktion einzelner Bauteile hervorrufen können. Durch die immer weiter fortschreitende Systemintegration kann dies zum Ausfall ganzer Systeme führen.

Durch die Verwendung des mittels des erfindungsgemäßen Verfahrens hergestellten Kunststoff-Verbundwerkstoffes als Schutzschicht für ein elektronisches Bauteil ist es möglich, dass dieses durch das Metallpulver bereits ausreichend abgeschirmt ist. Auf eine zusätzliche Abschirmung kann dann verzichtet werden. Dadurch ist es möglich, die Integration von Bauteilen weiter zu steigern, was sich wiederum positiv auf die Herstellungskosten elektronischer Bauteile oder Geräte auswirkt.

Um eine möglichst große Packungsdichte des Metallpulvers zu erreichen, liegen die Partikel des Metallpulvers nach einer Variante des erfindungsgemäßen Verfahrens als multimodale Gemische sphärischer Partikel, bevorzugt als trimodale Gemische sphärischer Partikel, mit mittleren Partikeldurchmessern von 0,1 µm und 500µm vor (bzw. zwischen 0,1 µm und 500µm), bevorzugt 0,5µm bis 250µm und besonders bevorzugt 1 µm bis 100µm.

Für andere Verwendungen kann es sinnvoll sein, nicht-sphärische erfindungsgemäße Partikel einzusetzen. In diesem Fall beziehen sich die in diesem Text genannten Angaben für Partikeldurchmesser auf den mittleren maximalen Durchmesser.

Besonders preisgünstig können erfindungsgemäß die einzelnen Partikel des Metallpulvers unter Verwendung eines Gasphasenprozesses beschichtet werdenmittels einer Plasmaquelle, die eine Atmosphärendruck-Plasmaquelle ist. Bei Verwendung der Plasmaquelle wird die Beschichtung der Partikel gemäß den erfindungsgemäßen Verfahren bevorzugt mit folgenden Verfahrensschritten durchgeführt: Herstellen eines Plasma mittels der Plasmaquelle, Vermengen des Plasma mit einem Monomer und dem Metallpulver und Bilden der elektrisch isolierende Schicht auf den Oberflächen der einzelnen Partikel des Metallpulvers aufgrund der Wechselwirkung des Plasma mit dem Monomer. Durch das Vermengen des Plasmas mit dem Monomer und dem Metallpulver entstehen z.B. reaktiven Radikale aus dem Monomer aufgrund einer Reaktion des Monomers mit dem Plasma. Diese Schritte werden bei Atmosphärendruck durchgeführt. Unter Monomer wird eine flüssige oder gasförmige chemische Substanz verstanden, die unter Einwirkung des Plasma zur Schichtabscheidung führt. Ein Beispiel ist Hexamethyldisiloxan. Die Schicht ist organischer, anorganischer, metallorganischer oder halbmetallorganischer Art.

Sofern eine elektrische Isolierung der einzelnen Partikel des Metallpulvers erwünscht ist, erfolgt diese erfindungsgemäß mittels der Abscheidung einer geeigneten plasmapolymeren Schicht, die ein isolierendes Material darstellt, welches organisch, anorganisch, metallorganisch oder halbmetallorganischer Art sein kann, z.B. basierend auf siliziumorgansichen Verbindungen. Die aufgebrachten Schichten weisen dabei bevorzugt eine Schichtdicke zwischen 10nm und 10µm, besonders bevorzugt zwischen 20nm und 200nm auf, wodurch z.B. die erreichbaren Packungsdichten der erfindungsgemäß verwendeten multimodalen Gemische sphärischer Metallpulver im Kunststoff-Verbundwerkstoffes nur bedingt reduziert werden. Die Schicht kann insbesondere organischer, anorganischer, metallorganischer oder halbmetallorganischer Art sein.

Die elektrische Isolierung wird bevorzugt mittels des Plasmaverfahrens aufgebracht. Durch die oben beschriebenen Eigenschaften der plasmapolymeren Schichten bestehen Vorraussetzungen, dass die Partikel vollständig und umschließend beschichtet werden, um einen elektrischen Kontakt zwischen zwei beschichteten sphärischen Partikeln auszuschließen. Dies gilt umso mehr, als die bevorzugte Düse (s. o.) verwendet wird.

Durch ein wiederholtes Aufbringen von Schichten auf die einzelnen Partikel, was gemäß einer weiteren Variante des erfindungsgemäßen Verfahrens vorgesehen ist, können dickere und damit auch dichtere Schichtabscheidungen erreicht werden. Dies kann für eine Vielzahl der weiter unten aufgeführten zusätzlichen Anwendungsbereiche von Vorteil sein.

Mittels des erfindungsgemäßen Verfahrens ist es möglich, relativ geringe Schichtdicken, insbesondere von 0,01 µm bis 10µm (bzw. zwischen 10 nm und 10 µm) zu erreichen, mit denen man trotzdem z.B. eine relativ hohe elektrische Isolationswirkung erreicht. Somit ist es möglich, dass die einzelnen Partikel des Metallpulvers zwar elektrisch isolierend sind, deren thermische Leitfähigkeit jedoch nur zu einem relativ geringen Maße reduziert wird. Somit ist es möglich, einen Kunststoff-Verbundwerkstoff mit einer relativ großen thermischen Leitfähigkeit herzustellen (zwischen 2 und 20 W/mK). Bevorzugte Schichtdicken sind von 100nm bis 5µm, besonders bevorzugt von 500nm bis 2,5µm.

Bilden die Metalle aufgrund von Oberflächeneffekten an Luftsauerstoff eine Oxidschicht aus, wie dies z.B. bei Metallen wie Kupfer, Aluminium oder Eisen der Fall sein kann, so ist die Verschiebung der Perkulationsschwelle, ab der sprunghaft die elektrische Leitfähigkeit ansteigt, mit den hier beschriebenen Materialien und Verfahren in besonderem Maße in Richtung guter Isolierung zu verschieben.

Teil der Erfindung ist auch ein Verfahren zum Herstellen eines Kunststoffverbundwerkstoffes, aufweisend die folgenden Verfahrensschritte:
- Beschichten eines Metallpulvers gemäß einem der oben genannten erfindungsgemäßen Verfahren, wobei die als bevorzugt bezeichneten Verfahren ebenfalls bevorzugt eingesetzt werden, und
- Mischen der beschichteten Partikel des Metallpulvers mit einem Kunststoff.

Der erfindungsgemäße Kunststoff-Verbundwerkstoff kann insbesondere zur Ummantelung eines elektronischen Bauteils verwendet werden.

Teil der Erfindung ist auch ein Partikel, der herstellbar nach einem der erfindungsgemäßen Verfahren ist. Dieser Partikel umfasst regelmäßig ein Metall in sphärischer Form sowie eine plasmapolymere Beschichtung.

Teil der Erfindung ist auch ein Kunststoffverbundwerkstoff, der einen Kunststoff und erfindungsgemäße Partikel umfasst.

Bestandteil der Erfindung ist darüber hinaus ein elektronisches Bauteil mit einer vollständigen oder teilweisen Ummantelung aus einem erfindungsgemäßen Kunststoffverbundwerkstoff.

Aufgrund der besonderen Eigenschaften des erfindungsgemäßen Partikels (besonders in seinen bevorzugten Ausgestaltungsformen) bzw. des erfindungsgemäßen Verbundwerkstoffes gehört deren Verwendung zur Verbesserung der Wärmeleitfähigkeit an oder in den Teilen eines Körpers ebenfalls zur Erfindung. Durch die vom Fachmann leicht vorzunehmende Wahl der plasmapolymeren Beschichtung in den erfindungsgemäßen Partikeln kann die Wärmeleitfähigkeit des jeweilig verwendeten Metalles zu einem erfreulich hohen Maß erhalten bleiben.

Die erfindungsgemäßen Partikel besitzen bei der Wahl geeigneter Abscheidungsbedingungen und Monomere für den Plasmapolymerisationprozess eine plasmapolymere Schicht, die die Metalle vor medienbedingter Alterung insbesondere Korrosion schützt. Dementsprechend ist es vorteilhaft, die erfindungsgemäßen Partikel oder einen erfindungsgemäßen Kunststoffverbundwerkstoff gezielt zum Korrosionsschutz von wenigstens einen Teil eines Körpers einzusetzen auf oder in den die erfindungsgemäßen Partikel bzw. der erfindungsgemäße Kunststoffverbundwerkstoff ein- bzw. aufgebracht sind. Bei der Verwendung von Metall in sphärischer Form für die Beschichtung lassen sich hohe Packungsdichten in den erfindungsgemäßen Partikel erreichen (vgl. oben), was auch von Vorteil für den Korrosionsschutz ist.

Aufgrund der besonderen Eigenschaften der erfindungsgemäßen Partikel bzw. des erfindungsgemäßen Kunststoffverbundwerkstoffes ist deren Verwendung zur Veränderung der Lichtreflektionseigenschaften eines Körpers ebenfalls Bestandteil der Erfindung. Dies kann z.B. durch die Beimischung der erfindungsgemäßen Partikel zu einem Lack erfolgen, welcher auf die Oberfläche oder auf Teile der Oberfläche eines Körpers aufgetragen wird. Aufgrund der plasmapolymeren Beschichtung erhalten bei geeigneter Wahl der Zusammensetzung der Beschichtung die Metallbestandteile ihre Eigenschaften wie z.B. den metallischen Glanz in besonderer Weise: Zum einen sind die Metalle selbst gegen Korrosion geschützt, zum anderen kann durch die Wahl der Beschichtungszusammensetzung das Lichtdurchlässigkeitsverhalten der Beschichtung gut gesteuert werden. Besonders bevorzugt sind hierbei im Wesentlichen transparente Schichten. Besonders bevorzugt ist in diesem Zusammenhang der Einsatz der erfindungsgemäßen Partikel in einem Metalliclack. Ganz besonders bevorzugt ist, dass die erfindungsgemäßen Partikel beschichtete Aluminiumflakes sind.

Ebenfalls aufgrund ihrer besonderen Eigenschaften sind die erfindungsgemäßen Partikel bzw. der erfindungsgemäße Kunststoffverbundwerkstoff zur Beeinflussung der Benetzungseigenschaften eines Körpers geeignet. Mit einer durch den Fachmann leicht vorzunehmenden Wahl der Beschichtung der Partikel lassen sind beispielsweise hydrophobe bzw. hydrophile Eigenschaften an der Oberfläche der erfindungsgemäßen Partikel und damit auch in dem erfindungsgemäßen Kunststoffverbundwerkstoff einstellen. Durch Aufbringen der erfindungsgemäßen Partikel/des erfindungsgemäßen Kunststoffverbundwerkstoffes auf Teile eines Körpers oder den gesamten Körper wären dann selbstverständlich auch dessen Benetzungseigenschaften beeinflusst.

Ebenfalls aufgrund der besonderen Eigenschaften der erfindungsgemäßen Partikel bzw. des erfindungsgemäßen Verbundwerkstoffes ist deren Verwendung zur Dämpfung und/oder Abschirmung von elektromagnetischer Strahlung Bestandteil der Erfindung. Diese Verwendung bietet sich zum Schutz von elektronischen Bauteilen gegenüber der elektromagnetischen Strahlung von benachbarten elektronischen Bauteilen an.

Allgemeiner ist die Verwendung zum Schutz vor oder der Verringerung von elektromagnetischer Strahlung durch die erfindungsgemäßen Partikel enthaltende Schichten aus beiden senkrecht zur Schicht stehenden Raumrichtungen ("innen/außen") sinnvoll. Damit können nicht nur elektromagnetisch empfindliche Bauteile, sondern auch Lebewesen vor von elektromagnetischen Strahlungsquellen ausgehender Strahlung geschützt werden. Dieser Schutz kann bei geeigneter erfindungsgemäßer Verwendung auch auf ganze Räume ausgedehnt werden.

Ein Ausführungsbeispiel eines erfindungsgemäßen Verfahrens und ein Ausführungsbeispiel eines elektronischen Bauteils sind in den beigelegten schematischen Zeichnungen dargestellt. Es zeigen:
- Fig. 1: Vorrichtung zum Herstellen beschichteter Partikel eines Metallpulvers,
- Fig. 2: ein beschichtetes Partikel des Metallpulvers und
- Fig. 3: ein elektronisches Bauteil.

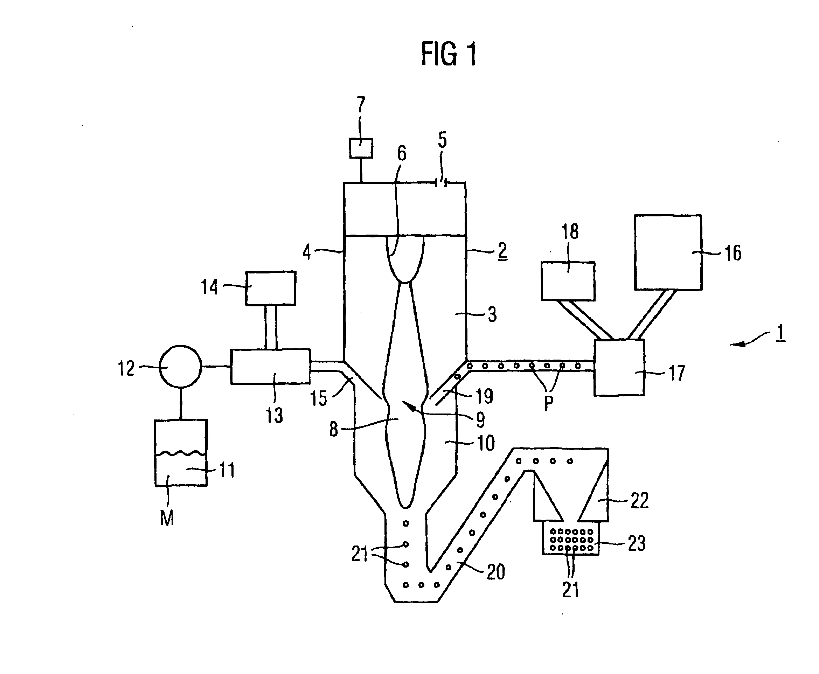

Die Fig. 1 zeigt eine Vorrichtung 1 zum Herstellen beschichteter Partikel eines Metallpulvers.

Die in der Fig. 1 gezeigte Vorrichtung 1 umfasst im vorliegenden Ausführungsbeispiel eine Atmosphärendruck-Plasmaquelle 2, die wiederum einen Entladungsraum 3 mit einer Außenwand 4 aufweist. Die Außenwand 4 ist mit einer Öffnung 5 versehen, durch die ein Ionisationsgas in den Entladungsraum 3 eingeleitet werden kann. Die Atmosphärendruck-Plasmaquelle 2 umfasst ferner eine Elektrode 6, die mit einer Spannungsversorgung 7 verbunden ist.

Zur Herstellung eines gepulsten Plasma wird zwischen der Außenwand 4 und der Elektrode 6 eine hochfrequente Wechselspannung angelegt und Ionisationsgas durch die Öffnung 5 in den Entladungsraum 3 geblasen. Durch die Wechselspannung wird das Plasma gezündet und dadurch, dass das Ionisationsgas durch die Öffnung 5 in den Entladungsraum 3 geblasen wird, bläst ein Plasmastrahl 8 durch eine Öffnung 9 aus dem Entladungsraum 3 in eine Reaktionskammer 10 der Vorrichtung 1.

In der Fig. 1 ist ferner ein Reservoir 11 dargestellt, in dem sich im Falle des vorliegenden Ausführungsbeispiels ein Monomer M (Precursor), bei dem es sich im Falle des vorliegenden Ausführungsbeispieles um Hexamethyldisiloxan handelt, befindet.

Im Falle des vorliegenden Ausführüngsbeispiels wird Monomer M aus dem Reservoir 11 kontinuierlich mit einer Schlauchpumpe 12 entnommen und zu einem Zerstäuber 13 geleitet. An den Zerstäuber 13 ist ferner eine Trägergasquelle 14 angeschlossen, aus der das Trägergas, z.B. Sauerstoff, in den Zerstäuber 13 geleitet wird.

Im Zerstäuber 13 wird das Monomer M in ein Aerosol oder in Dampfform überführt und mit dem Trägergas durch eine Öffnung 15 der Reaktionskammer 10 in die Reaktionskammer 10 geblasen.

In der Fig. 1 ist außerdem ein Reservoir 16 dargestellt, in dem sich im Falle des vorliegenden Ausführungsbeispiels ein Metallpulver, bei dem es sich im Falle des vorliegenden Ausführungsbeispieles um ein Kupferpulver handelt, befindet. Die einzelnen Partikel P des Kupferpulvers haben im Falle des vorliegenden Ausführungsbeispiels ein Größe von ca. 0,1µm bis 500µm und liegen als Gemisch mit definierten Größenverteilungen vor.

Im Falle des vorliegenden Ausführungsbeispiels ist das Reservoir 16 mit einer Fördereinrichtung 17 verbunden, die kontinuierlich aus dem Reservoir 16 Kupferpulver entnimmt. Die Fördereinrichtung 17 ist ferner mit einer mit einer Trägergasquelle 18 verbunden, aus der das Trägergas, z.B. Stickstoff, in die Fördereinrichtung 17 geleitet wird.

In der Fördereinrichtung 17 wird das Kupferpulver mit dem Stickstoff der Trägergasquelle 18 vermischt und durch eine Öffnung 19 der Reaktionskammer 10 in die Reaktionskammer 10 geblasen.

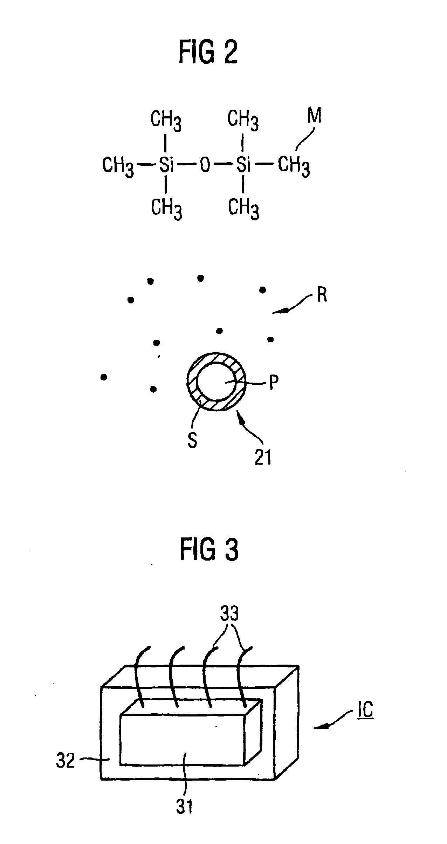

Das in die Reaktionskammer 10 geblasene Monomer Hexamethyldisiloxan reagiert mit dem Plasma des Plasmastroms 8 in der Reaktionskammer 10, wodurch aus dem Monomer Hexamethyldisiloxan reaktive Radikale R erzeugt werden. Dies ist in der Figur 2 dargestellt.

Die reaktiven Radikale R scheiden sich wiederum auf den einzelnen Oberflächen der Kupferpartikel P des in die Reaktionskammer 10 geblasenen Kupferpulvers ab. Die reaktiven Radikale R vernetzen dabei nicht nur mit der Oberfläche eines Kupferpartikel P, sondern auch untereinander, wodurch die einzelnen Kupferpartikel P mit einer geschlossenen Umhüllung beschichtet werden. Diese Umhüllung ist eine plasmapolymere Schicht, die elektrisch isolierend ist. Im Falle des vorliegenden Ausführungsbeispiels handelt es sich bei der plasmapolymere Schicht S um eine siliziumorganische Schicht.

Durch den Plasmastrahl 8 werden die beschichteten Kupferpartikel 21 durch einen mit der Reaktionskammer 10 verbundenen Kanal 20 zu einen Zyklon 22 geführt. Der Zyklon 22 ist mit einer geeigneten Ablufteinheit versehen, wodurch die einzelnen beschichteten Kupferpartikel 21 in einen Auffangbehälter 23 abgeführt werden.

Die einzelnen beschichteten Kupferpartikel 21 werden zur Herstellung eines elektrisch isolierenden Kunststoff-Verbundwerkstoff verwendet. Dazu werden die einzelnen beschichteten Kupferpartikel 21 einem in den Figuren nicht dargestellten Ausgangskunststoff als Füllstoffe beigemischt.

Der Kunststoff-Verbundwerkstoff wird im Falle des vorliegenden Ausführungsbeispiels folgendermaßen hergestellt: Der Ausgangskunststoff, z.B. Epoxidharz, wird mit einem Anhydrid Härter (Rotadur) in einem Dreihalskolben im Verhältnis 100 zu 90 eingewogen, auf 80° Celsius temperiert und mit einem Teflonflügelblattrührer homogenisiert. Es entsteht eine Harz-Härter-Mischung. Die beschichteten Kupferpartikel 21 werden zur temperierten Harz-Härter-Mischung gegeben und 0,2 gew. % eines Beschleunigers, beispielsweise N-Benzyldimethylamin, bezogen auf die Harz-Härter-Mischung zugetropft. Nachdem die beschichteten Kupferpartikel 21 der Harz-Härter-Mischung zugegeben wurden, wird die daraus entstehende Mischung bei 80° Celsius gerührt und bei ca. 20 Millibar Unterdruck entgast. Diese Mischung stellt den elektrisch isolierenden Kunststoff-Verbundwerkstoff dar, der bevorzugt als Schutzschicht oder Schutzummantelung elektronischen Bauteilen verwendet wird.

Die Fig. 3 zeigt als Beispiel eines elektronischen Bauteils einen integrierten Schaltkreis IC, dessen elektronisch aktiver Teil 31 in eine Schutzummantelung 32 gegossen ist. Die Schutzummantelung besteht im Falle des vorliegenden Ausführungsbeispiels aus dem elektrisch isolierenden Kunststoff-Verbundwerkstoff wie oben stehend beschrieben. Der elektronisch aktive Teil 31 des integrierten Schaltkreises IC ist mit elektrischen Anschlüssen 33 versehen, die durch die Schutzummantelung 32 geführt sind.

Obwohl die vorliegende Erfindung anhand eines bevorzugten Ausführungsbeispiels beschrieben wurde, ist die Erfindung nicht auf diese beschränkt, sondern auf vielfältige Weise modifizierbar. Insbesondere braucht das Metallpulver nicht notwendigerweise ein Kupferpulver sein. Andere metallische Materialien, insbesondere Aluminium, Silber oder Magnesium, sowie deren Legierungen und Gemische dieser Materialien sind auch verwendbar.

Um die Wärmeleitfähigkeiten elektrisch isolierender Kunststoffverbundwerkstoffe mit unterschiedlichen Füllstoffen zu bestimmen, werden jeweils Platten aus den Kunststoff-Verbundwerkstoffen hergestellt, deren Flächen plan parallel sind. Die einzelnen plan parallelen Platten werden hergestellt, indem, wie prinzipiell oben stehend beschrieben, Harz-Härter-Mischungen mit verschiedenen Füllstoffen, z.B. beschichteten Kupfer-, Eisen-, Aluminium-, Silber- oder Magnesiumpartikeln, in eine mit einem Trennmittel, z.B. QZ13, vorbehandelte und vorgeheizte Gussform gefüllt und bei 140° Celsius ausreagiert werden.

Das Ergebnis der durchgeführten Versuche ist in den folgenden Tabellen zusammengefasst:

**Füllstoffeigenschaften:**

| Material | Wärmeleitfähig keit | Dichte | Verteilung | Partikel-größe D₅₀-Wert |
|---|---|---|---|---|
| | [W/mK] | [g/cm3] | | [µm] |
| Eisen | 70 | 7,8 | monomodal | 100 |
| Eisen (beschichtet) | 70 | 7,8 | monomodal | 77 |
| Quarzmehl | 1-10 | 2,65 | monomodal | 74 |
| Eisen (beschichtet) | 70 | 7,46 | monomodal | 16 |
| Quarzmehl | 1-10 | 2,65 | monomodal | 25 |
| SCAN | 180-200 | 3,26 | monomodal | 24 |
| Aluoxid | 25-40 | 3,80 | monomodal | 25 |
| Eisen (beschichtet) | 70 | 7,8/7,46 | bimodal | 77/16 |
| Quarzmehl | 1-10 | 2,65 | bimodal | 74/10 |
| Kupfer (beschichtet) | 399 | 8,88 | bimodal | 18/90 |
| Kupfer (beschichtet) | 399 | 8,88 | bimodal | 18/90 |
| Kupfer (beschichtet) | 399 | 8,88 | bimodal | 18/90 |
| Kupfer (beschichtet) | 399 | 8,88 | trimodal | 18/90/500 |
| Aluminium (beschichtet) | 260 | 3,4 | bimodal | 30/120 |
| Aluminium (beschichtet) | 260 | 3,4 | trimodal | 30/120/390 |

**Eigenschaften des Kunststöffverbundwerkstoffes:**

| Material | Dichte | Volumenfüllgrad | Spez. Widerstand | Wärmeleitfähigkeit |
|---|---|---|---|---|
| | [g/cm3] | [%] | [kΩm] | [W/mK] |
| Eisen | 5,1 | 59,03 | 0,045 | 1,74 |
| Eisen (beschichtet) | 5,01 | 57,60 | 10⁵ | 1,71 |
| Quarzmehl | 1,83 | 43,06 | > 10⁶ | 0,45 |
| Eisen (beschichtet) | 4,83 | 57,95 | 10⁵ | 1,49 |
| Quarzmehl | 1,98 | 53,10 | > 10⁶ | 0,47 |
| SCAN | 2,23 | 49,72 | > 10⁶ | 1,43 |
| Aluoxid | 2,77 | 60,23 | > 10⁶ | 1,89 |
| Eisen (beschichtet) | 5,07 | 60,18 | 10⁶ | 1,76 |
| Quarzmehl | 2,13 | 64,14 | > 10⁶ | 0,53 |
| Kupfer (beschichtet) | 6,04 | 62,93 | > 10⁶ | 3,24 |
| Kupfer (beschichtet) | 5,76 | 59,30 | > 10⁶ | 3,14 |
| Kupfer (beschichtet) | 6,45 | 68,30 | > 10⁶ | 5,10 |
| Kupfer (beschichtet) | 7,13 | 77,23 | > 10⁶ | 9,21 |
| Aluminium (beschichtet) | 2,59 | 63,21 | > 10⁶ | 2,85 |
| Aluminium (beschichtet) | 2,95 | 79,34 | > 10⁶ | 4,58 |

Insbesondere ergibt ein Vergleich eines Kunststoffverbundwerkstoffes mit beschichteten Eisenpartikeln mit einem Kunststoff-Verbundwerkstoff mit unbeschichteten Eisenpartikeln der Partikelgröße 70 µm, dass beide KunststoffVerbundwerkstoffe jeweils eine Wärmeleitfähigkeit von ca. 1,7 W/mK haben. Der spezifische Widerstand des Kunststoff-Verbundwerkstoffes mit unbeschichteten Eisenpartikeln ist etwa 0,045 kΩm, der spezifische Widerstand des Kunststoff-Verbundwerkstoffes mit beschichteten Eisenpartikeln ist dagegen 730 kΩm. Ab einem elektrischen spezifischen Widerstand größer als 100 kΩm kann ein Kunststoff-Verbundwerkstoff als elektrisch isolierend angesehen werden.

## Patentansprüche

1. Verfahren zum Beschichten eines Metallpulvers, aufweisend folgende Verfahrensschritte:
Beschichten der einzelnen Partikel (P) eines Metallpulvers mit einer Schicht (S), wobei das Metallpulver ein Metallpulver aus Kupfer, Silber, Magnesium, Nickel, Kobalt, Titan, Zink, deren Legierungen und/oder Gemischen der Metallpulver und deren Legierungen ist,
wobei für die Beschichtung der einzelnen Partikel (P) eine Gasphasenabscheidung mittels einer Atmosphärendruck-Plasmaquelle (2) so durchgeführt wird, dass eine gasförmige Substanz, die mindestens Kohlenstoff-, Silizium- und/oder Schwefelatome enthält in einem Plasma angeregt und fragmentiert wird und eine Plasmapolymerisation durchgeführt wird und
wobei die Gasphasenabscheidung die folgenden Verfahrensschritte für die Beschichtung der Partikel (P) aufweist:
- Herstellen eines Plasma (8) mittels einer Atmosphärendruck-Plasmaquelle (2),
- Vermengen des Plasma (8) mit einem Monomer (M) und dem Metallpulver
und
- Bilden der Schicht (S) auf den Oberflächen der einzelnen Partikel (P) des Metallpulvers aufgrund der Wechselwirkung des Plasma (8) mit dem Monomer (M),
wobei das Verfahren bei Atmosphärendruck durchgeführt wird, und
wobei die Schicht (S) organisch, metallorganisch oder halbmetallorganisch ist.

2. Verfahren nach Anspruch 1, bei dem die Schicht (S) eine Schichtdicke zwischen 10nm und 10µm aufweist.

3. Verfahren nach einem der vorrangehenden Ansprüche, bei dem die Partikel (P) des Metallpulvers einen Durchmesser zwischen 0.1µm und 500µm haben.

4. Verfahren nach einem der vorangehenden Ansprüche, bei dem das Metallpulver ein multimodales, bevorzugt ein trimodales Gemisch sphärischer Partikel ist mit mittlerer Partikelgröße von 0,1 µm - 500 µm.

5. Verfahren nach einem der vorrangehenden Ansprüche, bei dem die einzelnen Partikel (P) mit mehreren Schichten (S) beschichtet werden.

6. Verfahren zum Herstellen eines Kunststoff-Verbundwerkstoffes, aufweisend folgende Verfahrensschritte:
- Beschichten eines Metallpulvers gemäß einem Verfahren nach einem der vorrangehenden Ansprüche und
- Mischen der beschichteten Partikel (21) des Metallpulvers mit einem Kunststoff.

7. Verfahren nach Anspruch 6, wobei die Partikel ein multimodales Gemisch sphärischer Partikel sind.

8. Beschichteter Partikel, bestehend aus einem Partikel (P) eines Metallpulvers, ausgewählt aus der Gruppe bestehend aus Kupfer, Silber, Magnesium, Nickel, Kobalt, Titan, Zink, deren Legierungen und einer Schicht (S), wobei die Schicht (S) eine plasmapolymeren Beschichtung des Metallpartikels ist und aus einem organischem, metallorganischem und/oder halbmetallorganischem Material besteht und wobei der Partikel (P) einen Durchmesser zwischen 0,1 µm und 500 µm besitzt und die Schichtdicke der Schicht (S) 0,01 µm bis 10 µm beträgt, wobei das beschichtete Metall sphärische Form besitzt.

9. Kunststoffverbundwerkstoff, umfassend einen Kunststoff und Partikel nach Anspruch 8.

10. Elektronisches Bauteil mit einer vollständigen oder teilweisen Ummantelung (32) aus einem Kunststoffverbundwerkstoff nach Anspruch 9.

11. Verwendung eines Partikels nach Anspruch 8 eines Verbundwerkstoffes nach Anspruch 9 zur Verbesserung der Wärmeleitfähigkeit an oder in Teilen eines Körpers.

12. Verwendung eines Partikels nach Anspruch 8 oder eines Verbundwerkstoffes nach Anspruch 9 zur Verbesserung des Korrosionsschutzes von wenigstens Teilen eines Körpers.

13. Verwendung eines Partikels nach Anspruch 8 oder eines Verbundwerkstoffes nach Anspruch 9 zur Veränderung der Lichtreflexionseigenschaften eines Körpers.

14. Verwendung eines Partikels nach Anspruch 8 oder eines Verbundwerkstoffes nach Anspruch 9 zur Beeinflussung der Benetzungseigenschaften eines Körpers.

15. Verwendung eines Partikels nach Anspruch 8 oder eines Verbundwerkstoffes nach Anspruch 9 zur Dämpfung und/oder Abschirmung von elektromagnetischer Strahlung.

## Claims

1. A method for coating a metal powder, having the following method steps:
coating the individual particles (P) of a metal powder with a layer (S), wherein the metal powder is a metal powder consisting of copper, silver, magnesium, nickel, cobalt, titanium, zinc, their alloys and/or mixtures of the metal powders and their alloys,
wherein for coating the individual particles (P) a vapour deposition by means of an atmospheric-pressure plasma source (2) is carried out such that a gaseous substance which contains at least carbon atoms, silicon atoms and/or sulphur atoms is excited in a plasma and fragmented and a plasma polymerisation is carried out, and
wherein the vapour deposition has the following method steps for the coating of the particles (P):
- producing a plasma (8) by means of an atmospheric-pressure plasma source (2),
- mixing the plasma (8) with a monomer (M) and the metal powder
and
- forming the layer (S) on the surfaces of the individual particles (P) of the metal powder on the basis of the interaction of the plasma (8) with the monomer (M),
wherein the method is carried out at atmospheric pressure, and
wherein the layer (S) is organic, organometallic or semi-organometallic.

2. A method according to Claim 1, in which the layer (S) has a layer thickness of between 10 nm and 10 µm.

3. A method according to one of the preceding claims, in which the particles (P) of the metal powder have a diameter of between 0.1 µm and 500 µm.

4. A method according to one of the preceding claims, in which the metal powder is a multimodal, preferably a trimodal, mixture of spherical particles with an average particle size of 0.1 µm - 500 µm.

5. A method according to one of the preceding claims, in which the individual particles (P) are coated with a plurality of layers (S).

6. A method for producing a plastics-material composite material, having the following method steps:
- coating a metal powder according to a method according to one of the preceding claims and
- mixing the coated particles (21) of the metal powder with a plastics material.

7. A method according to Claim 6, wherein the particles are a multimodal mixture of spherical particles.

8. A coated particle, consisting of a particle (P) of a metal powder, selected from the group consisting of copper, silver, magnesium, nickel, cobalt, titanium, zinc, their alloys and a layer (S), wherein the layer (S) is a plasma polymeric coating of the metal particle and consists of an organic, organometallic and/or semi-organometallic material, and wherein the particle (P) has a diameter of between 0.1 µm and 500 µm and the layer thickness of the layer (S) is 0.01 µm to 10 µm, wherein the coated metal has a spherical form.

9. A plastics-material composite material, comprising a plastics material and particles according to Claim 8.

10. An electronic component with a complete or partial covering (32) made of a plastics-material composite material according to Claim 9.

11. Use of a particle according to Claim 8 of a composite material according to Claim 9 to improve the thermal conductivity on or in parts of a body.

12. Use of a particle according to Claim 8 or of a composite material according to Claim 9 to improve the corrosion protection of at least parts of a body.

13. Use of a particle according to Claim 8 or of a composite material according to Claim 9 to change the light reflection properties of a body.

14. Use of a particle according to Claim 8 or of a composite material according to Claim 9 to influence the wetting properties of a body.

15. Use of a particle according to Claim 8 or of a composite material according to Claim 9 for damping and/or shielding from electromagnetic radiation.

## Revendications

1. Procédé de revêtement d'une poudre métallique, comprenant les étapes de procédé suivantes :
Revêtement des différentes particules (P) d'une poudre métallique d'une couche (S), la poudre métallique étant une poudre métallique constituée de cuivre, argent, magnésium, nickel, cobalt, titane, zinc, de leurs alliages et/ou de mélanges de la poudre métallique et desdits alliages.
un dépôt chimique en phase gazeuse étant effectué pour le revêtement des différentes particules (P) à l'aide d'une source (2) de plasma à pression atmosphérique de telle sorte qu'une substance sous forme gazeuse contenant au moins des atomes de carbone, de silicium et/ou de soufre, soit excitée et fragmentée et qu'une polymérisation plasma soit effectuée et
le dépôt chimique en phase gazeuse présentant les étapes de procédé suivantes pour le revêtement des particules (P) :
- fabrication d'un plasma (8) à l'aide d'une source (2) de plasma à pression atmosphérique,
- mélange du plasma (8) avec un monomère (M) et la poudre métallique
et
- formation de la couche (S) sur les surfaces des différentes particules (P) de la poudre métallique grâce à l'effet combiné du plasma (8) et du monomère (M),
le procédé étant effectué à pression atmosphérique, et
la couche (S) étant organique, métallo-organique ou à moitié métallo-organique.

2. Procédé selon la revendication 1, dans lequel la couche (S) présente une épaisseur comprise entre 10 nm et 10 µm.

3. Procédé selon l'une quelconque des revendications précédentes, dans lequel les particules (P) de la poudre métallique ont un diamètre compris entre 0,1 µm et 500 µm.

4. Procédé selon l'une quelconque des revendications précédentes, dans lequel la poudre métallique est un mélange multimodal, de préférence un mélange trimodal, de particules sphériques d'une dimension de 0,1 µm à 500 µm.

5. Procédé selon l'une quelconque des revendications précédentes, dans lequel les différentes particules (P) sont revêtues de plusieurs couches (S).

6. Procédé de fabrication d'un matériau synthétique composite, comprenant les étapes de procédé suivantes :
- revêtement d'une poudre métallique conformément à un procédé selon l'une quelconque des revendications précédentes et
- mélange des particules revêtues (21) de la poudre métallique avec une matière synthétique.

7. Procédé selon la revendication 6, dans lequel les particules sont un mélange multimodal de particules sphériques.

8. Particule revêtue, constituée d'une particule (P) d'une poudre métallique, sélectionnée dans un groupe comprenant le cuivre, l'argent, le magnésium, le nickel, le cobalt, le titane, le zinc, leurs alliages, et d'une couche (S), la couche (S) étant un revêtement polymère plasma de la particule métallique et constituée d'une matière organique, métallo-organique et/ou à moitié métallo-organique, la particule (P) possédant un diamètre compris entre 0,1 µm et 500 µm, l'épaisseur de la couche (S) étant de 0,01 µm à 10 µm, et le métal revêtu possédant une forme sphérique.

9. Matériau synthétique composite, comprenant une matière synthétique et des particules selon la revendication 8.

10. Composant électronique ayant une gaine complète ou partielle (32) constituée d'un matériau synthétique composite selon la revendication 9.

11. Utilisation d'une particule selon la revendication 8 d'un matériau composite selon la revendication 9 en vue d'améliorer la conductivité thermique sur ou dans des parties d'un corps.

12. Utilisation d'une particule selon la revendication 8 ou d'un matériau composite selon la revendication 9 en vue d'améliorer la protection anticorrosion au moins de parties d'un corps.

13. Utilisation d'une particule selon la revendication 8 ou d'un matériau composite selon la revendication 9 en vue de modifier les propriétés de réflexion de la lumière d'un corps

14. Utilisation d'une particule selon la revendication 8 ou d'un matériau composite selon la revendication 9 en vue d'influer sur les propriétés de mouillage d'un corps.

15. Utilisation d'une particule selon la revendication 8 ou d'un matériau composite selon la revendication 9 en vue d'atténuer le rayonnement électromagnétique et/ou de faire écran à ce rayonnement.
